# NEUE EUROPÄISCHE PATENTSCHRIFT

(11) **EP 0 470 926 B2**
(45) Veröffentlichungstag und Bekanntmachung des Hinweises auf die Entscheidung über den Einspruch: **02.12.1998**
(45) Hinweis auf die Patenterteilung: 28.09.1994
(21) Anmeldenummer: 91810517.2
(22) Anmeldetag: 02.07.1991
(51) Int. Cl.: H05K 7/20

(54) **Luftkühlung von mit Leiterplatten bestückten Steuerschränken**
Air cooling for control cabinets equiped with circuit boards
Refroidissement à air pour armoires de commande équipées de cartes à circuit imprimé

(30) Priorität: 07.08.1990 CH 2575/90
(43) Veröffentlichungstag der Anmeldung: 12.02.1992
(73) Patentinhaber: ELMA Electronic AG, 8620 Wetzikon (CH)
(72) Erfinder: Scheibler, Edy, CH-8620 Wetzikon (CH)
(74) Vertreter: Trieblnig, Adolf

(56) Entgegenhaltungen:
- DE-A- 3 509 908
- GB-A- 2 174 193
- US-A- 3 868 158
- US-A- 4 736 274
- PRODUCT ENGENEERING vol. 34, no. 11, 27 Mai 1963, NEW YORK US Seiten 36 - 37; IRWIN SCHUSTER:"" 8 printed circuit""

## Beschreibung

Die Erfindung betrifft eine Luftkühlung von mit Leiterplatten bestückten Steuerschränken, die ein Gehäuse, mindestens ein kühlluftansaugendes Gebläse und ein Feld von parallelen Leiterplatten aufweisen, welche mit wärmeentwickelnden elektrischen Bauteilen versehen sind.

Eine Luftkühlung gemäß Oberbegriff von Anspruch 1 wird z.B. gezeigt in US-A- 3 868 158.

Steuerschränke oder Einschübe für Kleincomputer und allgemeine Steuerung, die mit Printplatten bestückt sind, weisen oft sehr unterschiedliche Leistungen pro Karte auf. Die pro Steckkarte an den elektrischen Bauteilen freigesetzte Verlustwärme muss an die Umgebung abgeführt werden. Die Temperatur an den elektrischen Bauteilen wird daher solange ansteigen, bis das Temperaturgefälle zur Umgebung gross genug ist, um die Wärme abzuführen. Die Temperatur an den elektrischen Bauteilen darfjedoch bestimmte Grenzwerte nicht überschreiten, da sonst eine Schädigung der Bauteile eintreten kann.

In der Praxis wird mit Luft einer bestimmten Eintrittstemperatur gekühlt, die sich am Austritt aus den Printplatten nur um einen zulässigen Wert ΔT erwärmt haben darf. So ist z.B. bei bestimmten Anwendungsfällen bei einer Eintrittstemperaturvon 30°C eine maximale Temperaturerhöhung von nur ΔT = 20° C zulässig.

Eine weitere Forderung an eine Luftkühlung von Printplatten besteht in möglichst geringem Platzbedarf ausserhalb der meist standarisierten Kartenfelder. Im Handel sind eine ganze Reihe von Gebläsen und Lüftern erhältlich, die als Modul mit geringer Bauhhöhe unter einem Kartenfeld plaziert werden können. Typische Fabrikate sind die Axiallüfter PAPST (Adresse: PAPST-MOTOREN GmbH., Postfach 1435, D-7742 St. Georgen/Schwarzwald), ETRI (Adresse: ETRI, 8, Rue Boutard, F-92200 Neuilly-surSeine), BOXER (Adresse: IMC COMPONENTS, 55 Eddy Street, Providence RI 02903/USA). Axiallüfter die direkt unter ein Kartenfeld gesetzt werden, entwickeln wegen der ungleichen Strömung in die über sie verlaufenden Kartenzwischenräume eine von Karte zu Karte unterschiedliche Kühlwirkung.

Hier schafft die Erfindung Abhilfe. Sie löst die Aufgabe, unterschiedliche Wärmebelastungen und Anströmungen an einem Kartenfeld so auszugleichen, dass ein ausgeglichenes Temperaturfeld in derAbluft aus den Printplatten entsteht. Gemäss der Erfindung nach Anspruch 1 wird die Aufgabe dadurch gelöst, dass der Querschnitt der Mindestöffnungen einer Schikane auf ein Mehrfaches des Mindestöffnungsquerschnittes einstellbar ist.

Die Vorteile der Erfindung sind darin zu sehen, dass generell die installierte Leistung für die Luftumwälzung besser genutzt ist und dass mit dem Montagezeitpunkt der Karten, an dem auch die Wärmebelastung der Karten bekannt ist, eine einfache Korrektur der Strömung für hoch belastete Karten vorgenommen wird. Die abhängigen Ansprüche 2 bis 7 beziehen sich auf vorteilhafte Weiterbildungen der Erfindung.

Im folgenden wird die Erfindung anhand von Ausführungsbeispielen beschrieben. Es zeigen:
- Fig. 1: Die perspektivische Seitenansicht eines geöffneten Kleincomputers mit Axiallüfern und Steckkartenfeld;
- Fig.2: einen vergrösserten perspektivischen Ausschnitt aus Fig. 1 mit Axiallüfer und Steckkarten;
- Fig. 3: einen schematischen Schnitt durch einen Teil eines Steckkartenfeldes und darunter liegendem Axiallüfter;
- Fig. 4: das gemessene Temperaturfeld für die Temperaturerhöhung ΔT am Austritt eines Steckkartenfeldes, welches keine Schikanen zur Strömungsverteilung aufweist;
- Fig. 5: das gemessene Temperaturfeld für die Temperaturerhöhung ΔT am Austritt eines Steckkartenfeldes, welches Schikanen zur Strömungsverteilung aufweist;
- Fig. 6: Ausführungsformen für Mindestöffnungen von Schikanen, die durch Herausbiegen erweiterbar sind; und
- Fig. 7: Ausführungsformen für Mindestöffnungen von Schikanen, die durch Entfernen von dafür vorgesehenen Schikanenabschnitten erweiterbar sind.

In den Figuren ist die Luftkühlung von mit Leiterplatten 3 bestückten Steuerschränken 1 gezeigt, die ein Gehäuse 2, mindestens ein kühlluftansaugendes Gebläse 12 und ein Feld von parallelen Leiterplatten 3 aufweist, welche mit wärmeentwickelnden, elektrischen Bauteilen versehen sind. Der Kühlluftstrom ist vom Gebläseeintritt 18 bis zum Eintritt 20 zwischen den Leiterplatten und weiter längs den Leiterplatten bis zum Austritt 21 kanalisiert. Jeder Eintritt 20 zu einem längs der Leiterplatten verlaufenden Kanal besteht aus einer Schikane 10 mit Mindestöffnungen 13, deren Querschnitt auf ein Mehrfaches des Mindestöffnungsquerschnittes einstellbar ist. Durch die Stauwirkung der Mindestöffnungen 13 baut sich vor diesen ein Druck auf, der einerseits eine gleichmässigere Strömungsverteilung über die Mindestöffnungen 13 bewirkt und der andererseits eine gezielte Vergrösserung des Luftdurchsatzes bei wärmemässig stark belasteten Leiterplatten 3 mit erweitertem Oeffnungsquerschnitt an den Schikanen 10 möglich macht.

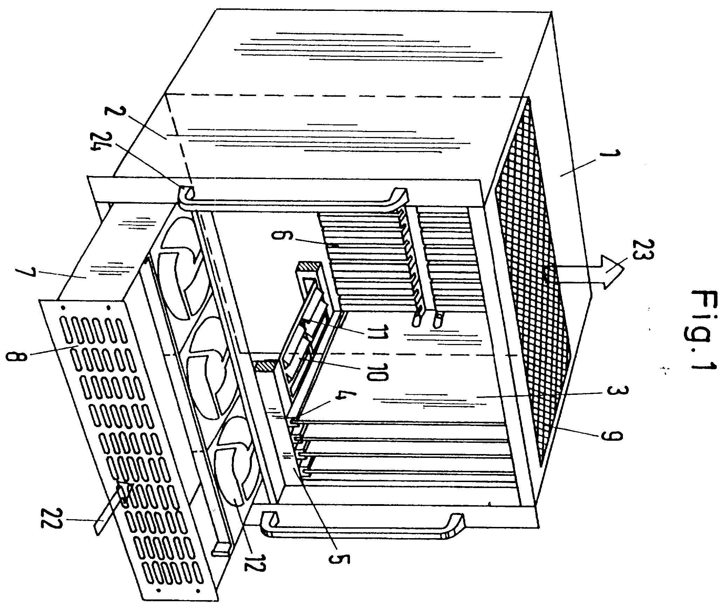

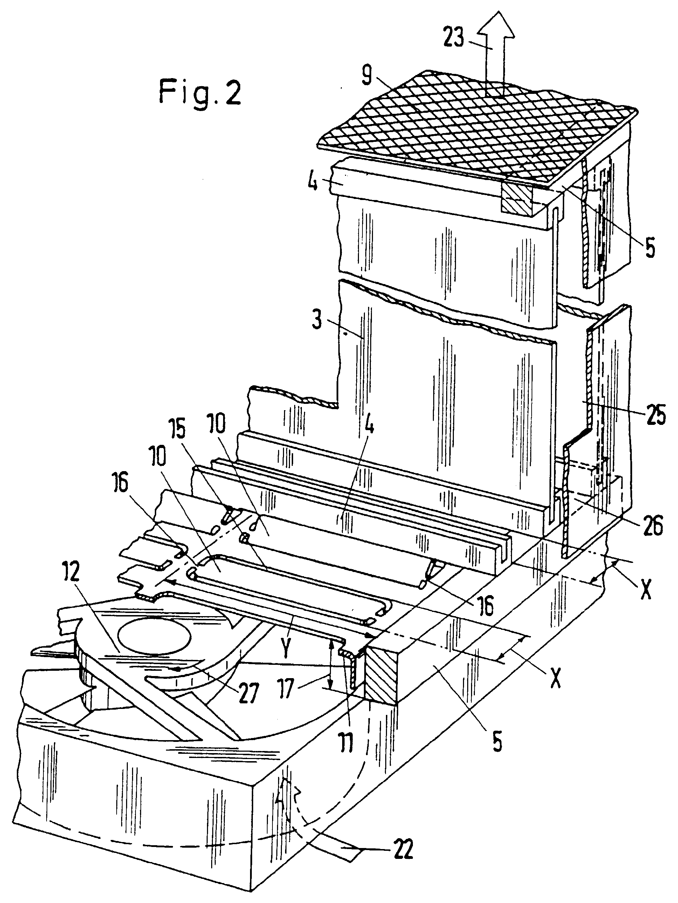

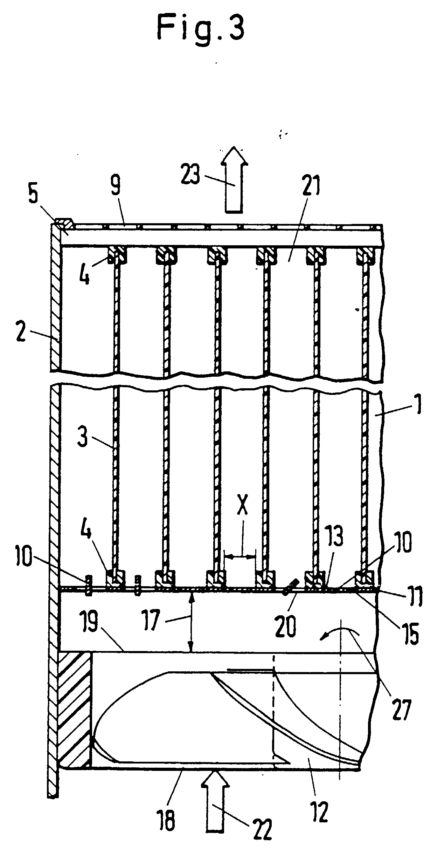

In den Fig. 1, 2 und 3 wird Kühlluft 22 von einem oder mehreren Gebläsen 12 angesogen. In Fig. 1 sind drei Axiallüfer 12 in einer Schublade 7 eingebaut, die mit einem Ansauggitter 8 versehen ist. Im montierten Zustand liegen die Lüfter 12 unter einem Feld von Steckkarten 3, die oben und unten in Führungsschienen 4 geführt sind und rückseitig in Steckerleisten 6 in einer Zwischenwand einrasten. Zur Frontseite hin werden die Kanäle 25 zwischen den Leiterplatten 3 durch Abdeckbleche 26 abgeschlossen.

Vom Gebläseaustritt 19 besteht je nach Abstand der unteren Führungselemente 4 eine Ausgleichsstrecke 17 bis zum Eintritt 20 zwischen benachbarten Leiterplatten 3. Alle Eintritte 20, die zu einem Kanal 25 längs der Leiterplatten 3 führen, sind mit einer Schikane 10 versehen, die Mindestöffnungen 13 aufweist. Verglichen mit einer Ausführung ohne Schikanen 10 senkt der zusätzliche Druckverlust an den Schikanen 10 den Luftdurchsatz entsprechend der Charakteristik der Gebläse 12. Gleichzeitig findet eine bessere Druckverteilung über alle Schikanen 10 statt, die zu einer gleichmässigen Luftverteilung führt. Mit der Wahl eines Querschnitts für die Mindestöffnungen 13 auf einer Länge Y, der etwa 10% der Durchtrittsfläche X . Y ohne Schikane entspricht, werden optimale Verhältnisse bei der Kartenteilung 2 cm (0,8 Zoll) erreicht. Der Abstand X entspricht dabei der lichten Weite zwischen den unteren Führungselementen 4, die auf Stützen 5 angeordnet sind. Für die Karten, welche gegenüber der Mehrheit der Karten höhere Wärmebelastungen aufweisen, werden die Mindestöffnngen 13 gezielt bei der Montage der Karten erweitert, wobei eine Vergrösserung auf ein Mehrfaches des Querschnitts der Mindestöffnungen 13 möglich ist. In der Regel machen diese wärmemässig hoch belasteten Karten weniger als 30% aller Karten 3 aus.

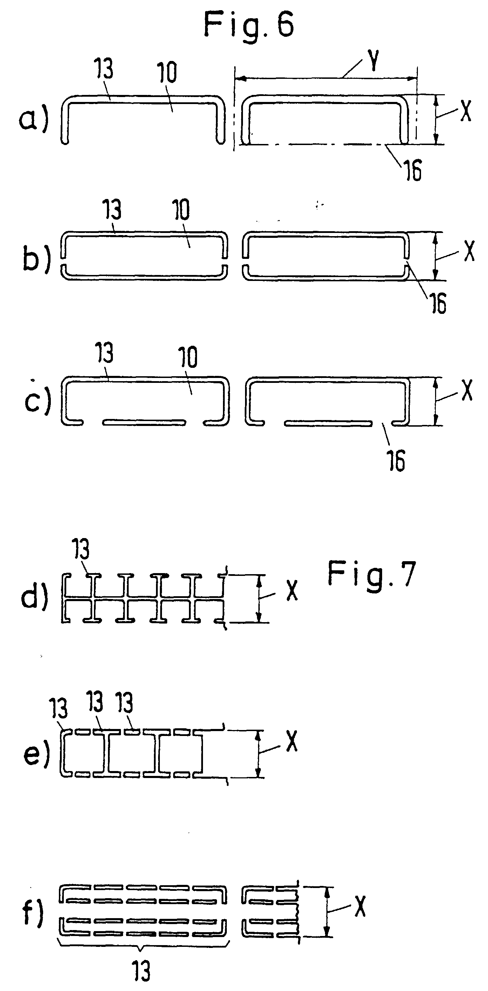

Fig. 6 und 7 zeigen verschiedene Ausführungsformen für die Gestaltung von Mindestöffnungen 13 an den Schikanen 10. Besonders gute Wärmeübergänge wurden mit Ausführungen der Fig. 6 erzielt, bei denen die Mindestöffnungen 13 als Schlitze 15 auf der Seite der bestückten Karten 3 angrenzend an die unteren Führungselemente angebracht sind und durch Herausbiegen von Schikanenmaterial die Schlitze 15 zur Mitte des Kanals 25 hin vergrössert werden, wobei das herausgebogene Schikanenmaterial wie ein Leitblech wirkt. Zur Feststellung der Biegeachse sind plastisch deformierbare Gelenke 16 vorgesehen. Die Mindestöffnungen sind z.B. im Raster der Führungselemente 4 in einen Zwischenboden 11 aus Blech gestanzt, der an den unteren Führungselementen 4 anliegt. Bei der Montage genügt es, mit einer Flachzange die Lappen des Schikanen-materials für hoch wärmebelastete Karten um 90° abzubiegen und für weniger hoch belastete Kartenn um 45° abzubiegen. Aehnlich zeigt die Fig. 7 Anordnungen von Mindestöffnungen, die bei einem spröden Werkstoff der Schikanen wie unter d) durch Ausbrechen von Material oder allgemein wie unter e), f) durch Entfernen von Trennstegen und von Schikanenmaterial vergrössert werden.

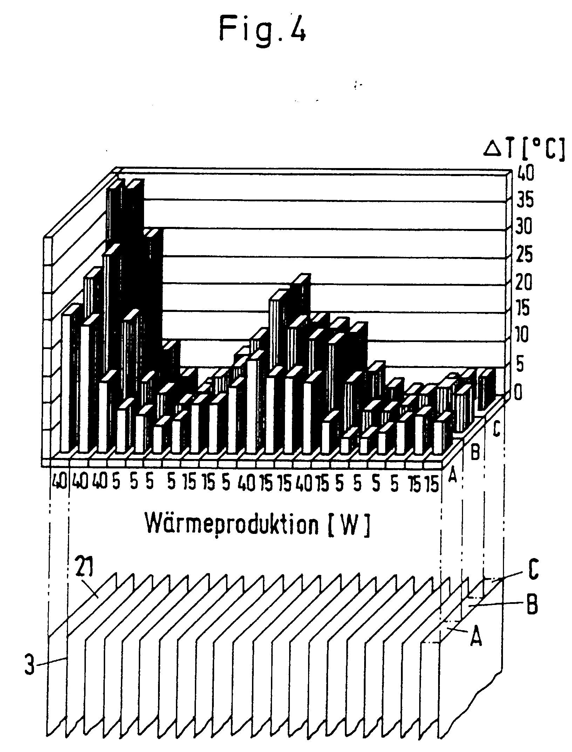

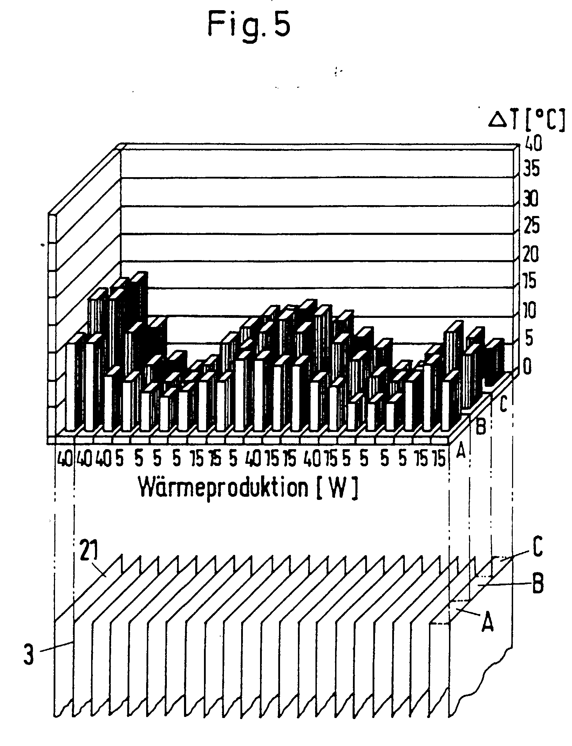

Die Wirksamkeit der Schikanen 10 ist im Vergleich zwischen den Fig. 4 und 5 dargestellt. Die Figuren zeigen im unteren Teil ein Feld von Printplatten 3 mit den Austritten 21 der Kühlluft Pro Austritt 21 wurde in den Bereichen A, B, C zwischen zwei benachbarten Printplatten 3 die Temperaturerhöhung ΔT gemessen. Im oberen Teil der Fig. 4 und 5 ist das entsprechende Temperaturfeld für die lokalen Temperaturerhöhungen ΔT dargestellt. Auf der Abszisse sind die mit Ohmschen Widerständen simulierten Wärmebelastungen in Watt für die jeweilige Printplatte angegeben. Die Säulen in Richtung der Ordinate geben mit ihrer Höhe die gemessene Temperaturerhöhung in °C an. Als Einfluss der Schikanen 10 lässt sich eine Glättung erkennen, indem maximale und minimale Temperaturerhöhungen ΔT zu einem Mittelwert hin tendieren.

## Patentansprüche

1. Luftkühlung von mit Leiterplatten bestückten Steuerschränken (1), die ein Gehäuse (2), mindestens ein kühlluftansaugendes Gebläse (12) und ein Feld von parallelen Leiterplatten (3) aufweisen, welche mit wärmeentwickelnden elektrischen Bauteilen versehen sind, wobei der Luftstrom vom Gebläseeintritt (18) bis zum Eintritt (20) zwischen den Leiterplatten (3) und weiter längs den Leiterplatten (3) bis zum Austritt (21) kanalisiert ist und der Eintritt (20) zwischen zwei benachbarten Leiterplatten (3) eine Schikane (10) mit Mindestöffnungen (13) aufweist, dadurch gekennzeichnet, dass der Querschnitt jeder Mindestöffnung auf ein Mehrfaches des Mindestöffnungsquerschnittes einstellbar ist.

2. Luftkühlung nach Anspruch 1, dadurch gekennzeichnet, dass der Querschnitt der Mindestöffnungen (13) zwischen zwei Leiterplatten einer Fläche von 10% der Durchtrittsfläche zwischen den zwei Leiterplatten (3) entspricht.

3. Luftkühlung nach Anspruch 2, dadurch gekennzeichnet, dass die Mindestöffnungen (13) jeweils aus Schlitzen gebildet sind, die angrenzend an die Leiterplatten (3) oder an Leiterplattenführungselemente (4) parallel zu diesen verlaufen.

4. Luftkühlung nach einem der Ansprüche 1 bis 3, dadurch gekennzeichnet, dass zur Erweiterung der Mindestöffnungen (13) Schikanenmaterial um plastisch deformierbare Gelenke (16) herausbiegbar ist.

5. Luftkühlung nach einem der Ansprüche 1 bis 3, dadurch gekennzeichnet, dass zur einmaligen Erweiterung der Mindestöffnungen (13) Schikanenmaterial ausbrechbar oder entfernbar ist.

6. Luftkühlung nach einem der Ansprüche 1 bis 5, dadurch gekennzeichnet, dass zwischen Gebläseaustritt (19) und den Öffnungen am Eintritt (20) zu den Leiterplatten (3) eine Ausgleichstrecke (17) besteht, die einen Ausgleich des Staudrucks unter den Öffnungen des Eintritts (20) bewirkt.

7. Luftkühlung nach einem der Ansprüche 1 bis 6, dadurch gekennzeichnet, dass die Schikanen (10) aus Blech bestehen.

## Claims

1. An air cooling system for control cabinets (1) equipped with circuit boards, which comprise a housing (2), at least one fan (12) which sucks in cooling air and a compartment of parallel circuit boards (3), which are provided with heat-developing electrical components, whereby the air flow is guided from the fan inlet (18) to the inlet (20) between the circuit boards (3) and on along the circuit boards (3) to the outlet (21) and the inlet (20) between two adjacent circuit boards (3) comprises a baffle plate (10) having minimum apertures (13),
**characterised in that** the cross section of each minimum aperture can be adjusted to a multiple of the cross section of the minimum aperture.

2. An air cooling system according to Claim 1,
**characterised in that** the cross section of the minimum apertures (13) between two circuit boards corresponds to an area of 10% the area of passage between the two circuit boards (3).

3. An air cooling system according to Claim 2,
**characterised in that** the minimum apertures (13) are respectively formed from slots, which extend adjacent to the circuit boards (3) or parallel to the guide elements (4) for said circuit boards.

4. An air cooling system according to one of Claims 1 to 3,
**characterised in that** to enlarge the minimum apertures (13), material from the baffle plate can be bent out around plastically deformable joints (16).

5. An air cooling system according to one of Claims 1 to 3,
**characterised in that** for the purpose of a one-off enlargement of the minimum apertures (13), baffle plate material can be broken off or removed.

6. An air cooling system according to one of Claims 1 to 5,
**characterised in that** between the fan outlet (19) and the apertures at the inlet (20) to the circuit boards (3), there is a compensating section (17) which equalizes the dynamic pressure under the apertures of the inlet (20).

7. An air cooling system according to one of Claims 1 to 6,
**characterised in that** the baffle plates (10) are made of sheet metal.

## Revendications

1. Refroidissement à air pour armoires de commande (1) équipées de cartes à circuits imprimés, qui comportent un carter (2), au moins un ventilateur (12) aspirant l'air de refroidissement et une zone de cartes à circuits imprimés (3) parallèles qui sont pourvues de composants électriques dégageant de la chaleur, le courant d'air étant canalisé depuis l'entrée du ventilateur (18) jusqu'à l'entrée (20) entre les cartes à circuits imprimés (3) et par la suite le long de celles-ci jusqu'à la sortie (21), et l'entrée (20) présentant, entre deux cartes à circuits imprimés (3) voisines, une chicane (10) avec des : ouvertures minimales (13), caractérisé en ce que la section transversale de chaque ouverture minimale peut être réglée à un multiple de la section transversale d'ouverture minimale.

2. Refroidissement à air selon la revendication 1, caractérisé en ce que la section transversale des ouvertures minimales (13) entre deux cartes à circuits imprimés correspond à une surface de 10 % de la surface de passage entre les deux cartes à circuits imprimés (3).

3. Refroidissement à air selon la revendication 2, caractérisé en ce que les ouvertures minimales (13) sont formées chacune par des fentes qui, adjacentes aux cartes à circuits imprimés (3) ou à des éléments de guidage (4) des cartes à circuits imprimés, s'étendent parallèlement à ceux-ci.

4. Refroidissement à air selon l'une des revendications 1 à 3, caractérisé en ce que pour élargir les ouvertures minimales (13) la matière des chicanes peut être repliée autour d'articulations (16) plastiquement déformables.

5. Refroidissement à air selon l'une des revendications 1 à 3, caractérisé en ce que pour élargir une fois les ouvertures minimales (13) la matière des chicanes peut être cassée ou enlevée.

6. Refroidissement à air selon l'une des revendications 1 à 5, caractérisé en ce qu'entre la sortie (19) du ventilateur et les ouvertures à l'entrée (20) menant aux cartes à circuits imprimés (3), il existe un trajet d'équilibrage (17) qui équilibre la pression dynamique entre les ouvertures de l'entrée (20).

7. Refroidissement à air selon l'une des revendications 1 à 6, caractérisé en ce que les chicanes (10) sont en tôle.
